# EUROPÄISCHE PATENTANMELDUNG

(11) **EP 1 705 152 A2**
(43) Veröffentlichungstag der Anmeldung: **27.09.2006**
(21) Anmeldenummer: 06111494.8
(22) Anmeldetag: 21.03.2006
(51) Int. Cl.: B81B 7/00

(54) **Verfahren und Vorrichtung, um Mikro- oder nanostrukturierte Bauteile gebrauchsbeständig zu gestalten**

(30) Priorität: 26.03.2005 DE 102005013974
(71) Anmelder: Krauss-Maffei Kunststofftechnik GmbH, 80997 München (DE)
(72) Erfinder: Buerkle, Erwin, 83671, Benediktbeuern (DE); Eichlseder, Martin, 94167, Tettenweis (DE); Klotz, Bernd, 85232, Gündig (DE); Burr, Steffen, 74626, Bretzfeld (DE)

(57) **Zusammenfassung**

Die vorliegende Erfindung betrifft ein Verfahren und eine Vorrichtung zur Herstellung eines Bauteils mit Mikro- oder Nanostruktur.

Um das Bauteil mit der Mikro- oder Nanostruktur gebrauchsbeständig zu gestalten wird vorgeschlagen, ein Substrat mit einem vernetzenden, insbesondere optisch transparenten Material zu überfluten. Dabei kann die Mikro- oder Nanostruktur auf einer Oberfläche des zu überflutenden Substrats oder auf einer Oberfläche der Überflutungsschicht selbst ausgebildet werden.

## Beschreibung

Die vorliegende Erfindung betrifft ein Verfahren und eine Vorrichtung zur Herstellung eines Bauteils mit einer Mikro- oder Nanostruktur, insbesondere mit einer Mikro- oder Nanostruktur auf der Oberfläche des Bauteils.

Es ist bekannt, Bauteile aus Kunststoffmaterial herzustellen, die beispielsweise auf deren Oberfläche eine Mikro- oder Nanostruktur aufweisen. Mit solchen Mikro- oder Nanostrukturen können bestimmte physikalische Effekte erreicht werden. Beispielsweise ist der Lotus-Effekt, also der Effekt einer wenig verschmutzenden oder selbstreinigenden Oberfläche, bekannterweise mit einer Nanostruktur realisierbar. Überdies ist es bekannt, optische Teilen mittels einer Mikro- oder einer Nanostruktur auf der Oberfläche des Teils zu entspiegeln.

Um solche mikro- oder nanostrukturierten Bauteile insbesondere durch einen Spritzgießprozess herstellen zu können, sind die Werkzeugkavitäten und die Verfahrensbedingungen in besonderer Weise auszugestalten. Es ist heute bereits technisch möglich, Mikrostrukturen durch Mikrozerspanung oder Laserbearbeiten herzustellen. Weitere Verfahren sind die LIGA-Technik (Litografisch-Galvanisches Verfahren) und das spezielle PVD-Verfahren (Physical Vapour Deposition). Auch die Probleme bei der Abformung solch kleiner Strukturen auf eine thermoplastische Kunststoffschmelze ist zum Teil bereits gelöst. Ebenfalls bekannt ist das Hinterspritzen von heißgeprägten, strukturierten Folien.

Problematisch bei den bisherigen aus thermoplastischen Kunststoffen hergestellten Produkten ist jedoch deren Gebrauchsbeständigkeit. Insbesondere sind solche aus thermoplastischem Material hergestellte Produkte nicht kratzfest.

Als Beispiel mag eine volltransparente Abdeckscheibe bei einem Armaturenbrett eines Fahrzeugs dienen. Eine solche optisch hochtransparente Abdeckscheibe sollte möglichst entspiegelt sein. Dazu kann eine Nanostruktur sowohl auf der Rück- wie auch auf der Frontseite aufgebracht sein. Die zu den Anzeigegeräten hinweisende und insgesamt gegenüber der Außenumgebung abgeschlossene Rückseite ist an sich unzugänglich und kann daher weder verschmutzen noch zerkratzt werden. Die in den Fahrgastraum eines Fahrzeugs hineinweisende Oberfläche hingegen kann sowohl verschmutzen als auch zerkratzt werden.

Aufgabe der vorliegenden Erfindung ist es, ein Verfahren und eine Vorrichtung zur Herstellung eines Bauteils mit einer Mikro- oder Nanostruktur anzugeben, welches gebrauchsbeständig ausgestaltet ist.

Diese Aufgabe wird durch die in den Ansprüchen 1 und 17 angegebenen Merkmale verfahrens- oder vorrichtungsmäßig gelöst.

Demgemäß ist ein Kerngedanke der vorliegenden Erfindung darin zu sehen, dass ein Substrat in einer Kavität mit einem vernetzenden, insbesondere optisch transparenten Material überflutet wird, wobei eine dünne Deckschicht ausgebildet wird. Das Material zum Überfluten des Substrates wird dabei so gewählt, dass es nach dem Vernetzen bzw. Aushärten den gestellten Anforderungen genügt und insbesondere kratzfest und gebrauchsbeständig ist. Dabei kann die Mikro- oder Nanostruktur auf dem zu überflutenden Material - nachfolgend auch als Substrat bezeichnet - vorgesehen sein. Die besagte Struktur kann aber auch während des Überflutungsvorgangs auf die Oberfläche des vernetzenden, insbesondere optisch transparenten Materials aufgebracht werden.

Damit eine Mikro- oder Nanostruktur zwischen dem Substrat und der Deckschicht im Sinne einer Entspiegelung wirksam ist, sollten die dafür gewählten Materialien nach dem Aushärten einen unterschiedlichen Brechungsindex aufweisen.

Als vernetzendes, insbesondere optisch transparentes Material eignet sich z. B. ein Polyurethanmaterial, ein Acrylmaterial, ein Epoxydharz oder ein Klarlack, insbesondere ein UV-aushärtbarer Klarlack, wobei diese Materialien beim Einfüllen vorzugsweise in einer niedrig viskosen Form vorliegen sollen, so dass auch dünne Kavitätsspalte problemlos befüllt werden können.

Nach dem Aushärten bilden sie die harte und die Gebrauchsbeständigkeit sicherstellende, insbesondere optisch transparente Deckschicht aus. Natürlich eignen sich auch alle anderen Materialien, die beim Einfüllen in einer möglichst niedrig viskosen Form vorliegen, aushärten können und dann insbesondere in einer optisch transparenten Form vorliegen.

Das Substrat kann beispielsweise in einem normalen Spritzgieß- oder Spritzprägeprozess hergestellt werden. Dabei kann bereits auf einer oder mehreren Seiten des Substrats eine Mikro- oder Nanostruktur aufgebracht werden. Sollte die Mikro- oder Nanostruktur nicht auf dem Substrat selbst, sondern lediglich auf der Deckschicht aufgebracht werden, so ist die entsprechende Struktur komplementär auf einer Kavitätsoberfläche vorzusehen. Diese Struktur bildet sich beim Einfüllen des Deckschichtmaterials auf dessen Oberfläche ab. Natürlich können beide Schichten, also sowohl das Substrat wie auch die Deckschicht eine entsprechende Struktur aufweisen. Auch ist es möglich, das Substrat an verschiedenen Stellen mit der Deckschicht zu überfluten oder schichtweise mehrmals zu überfluten.

Überdies ist es möglich, verschiedene Seiten des Substrates mit dem vernetzenden Material zu überfluten. So kann beispielsweise eine Kunststoffscheibe auf beiden Seiten überflutet werden, so dass auch auf beiden Seiten eine entsprechende kratzfeste und gebrauchsbeständige Oberfläche ausbildbar ist.

Eine besonders bevorzugte Ausführungsform ist dadurch gekennzeichnet, dass zwischen dem Substrat und der durch das Übergießen gebildeten Oberfläche ein Funktionselement eingebettet ist. Das Funktionselement kann als kompaktes Teil oder in Form einer Schicht ausgebildet sein, wobei letztere insbesondere auf der Oberfläche des Substrats angeordnet ist.

Als solches Funktionselement oder also solche Funktionsschicht kommen Elemente wie lichtleitende Glasfasern oder eine Leuchtfolie (OLEDs) in Betracht. Eine solchermaßen eingegossene, an sich empfindliche, elektrisch leitend ausgebildete Polymerschicht der Leuchtfolie kann über Zuleitungen von außen mit Strom versorgt werden. Alternativ können auch andere Stromversorgungen - wie eine Batterie oder ein Solarphotovoltaik-Element in die Schicht integriert werden. Eine Funktionsschicht kann beispielsweise als transparentes Anzeigeelement, als Display, als Beleuchtungs- oder Farbwechselelement verwendet werden. In letzterem Fall kann sie auch zur Wärmedämmung dienen, indem Sie eine Scheibe beispielsweise abdunkelt und damit eine Beschattung gegen einfallendes Licht ermöglicht.

Überdies lassen sich auch erst mit der Funktionsschicht gezielt Strukturen - beispielsweise Nanostrukturen - erzeugen; etwa solche Strukturen, die auf der Ober- und Unterschicht Licht beugende Eigenschaften hervorrufen.

Durch das Einfügen einer solchen Funktionsschicht in thermoplastische und/oder polyurethane Ober- und Unterschichten wird der Schutz der Funktionsschicht gewährleistet.

Die Funktionsschicht kann dabei auf ein Substrat aufgebracht werden, bevor dieses in einem Überflutungsschritt mit dem vernetzenden und aushärtenden Material beschichtet wird. Alternativ kann das Funktionselement in ein Spritzgießwerkzeug eingelegt, anschließend hinterspritzt und dann überflutet werden. Auch kann das Funktionselement nach dem Einlegen auch zuerst überflutet und dann hinterspritzt werden.

Das zu überflutende Substrat muss aber nicht in der oder einer anderen Kavität ausgebildet sein. Es kann auch anderweitig vor dem Überflutungsvorgang hergestellt werden und dann in die Kavität, in der mit dem entsprechenden Deckmaterial überflutet wird, eingebracht werden.

Vorrichtungstechnisch eignen sich die verschiedensten an sich bekannten Schließeinheiten durch Durchführung des Verfahrens. In jedem Fall sollte das Substrat zum Überfluten mit der Deckschicht in eine Kavität eingebracht oder gebildet werden, und zwar derart, dass sich zwischen dem Substrat und der Kavitätsoberfläche ein Kavitätsspalt ausbildet, in den das Deckschichtmaterial eingefüllt wird. Auf diese Weise ergibt sich nicht nur eine besonders genau definierte Schichtdicke. Es lässt sich auch eine entsprechende Mikro- oder Nanostruktur ohne weiteres auf die Deckschicht aufbringen.

In besonderer Weise eigenen sich Wendeplatten-, Schiebetisch- oder Drehtisch-Schließeinheiten, in denen verschiedene Formwerkzeuge aufgenommen und sowohl das Substrat wie auch das Überfluten des Substrats zyklusweise und zyklusgleich erfolgen kann. Solche Wendeplatten-, Schiebetisch- oder Drehtisch-Schließeinheiten sind aus dem Stand der Technik zur Genüge bekannt.

Eine besonders bevorzugte Ausführungsform ist dadurch gebildet, dass Spritzgieß- und Spritzprägeprozesse und PUR-RIM (PUR = Polyurethan; RIM = Reaction Injection Molding) miteinander kombiniert werden können.

Um die Abformgenauigkeit zu erhöhen, die Fließfähigkeit, insbesondere hinsichtlich längerer Fließwege, zu verbessern und die Vernetzungsreaktion zu unterstützen, kann das Werkzeug bzw. zumindest eine Kavitätsoberfläche beheizt werden. Damit würde sich auch ein Heißprägevorgang in einem Spritzwerkzeug ermöglichen lassen. Die Beheizung kann sowohl bei der Herstellung des Substrats wie auch bei der Überflutung des Substrats erfolgen. Natürlich kann im Gegenzug eine Kühlung erfolgen, um beispielsweise eine schnellere Entnahme zu gewährleisten. Eine solche Kühlvorrichtung könnte ebenfalls in einem Werkzeug, beispielsweise in Form von Kühlkanälen, integriert sein.

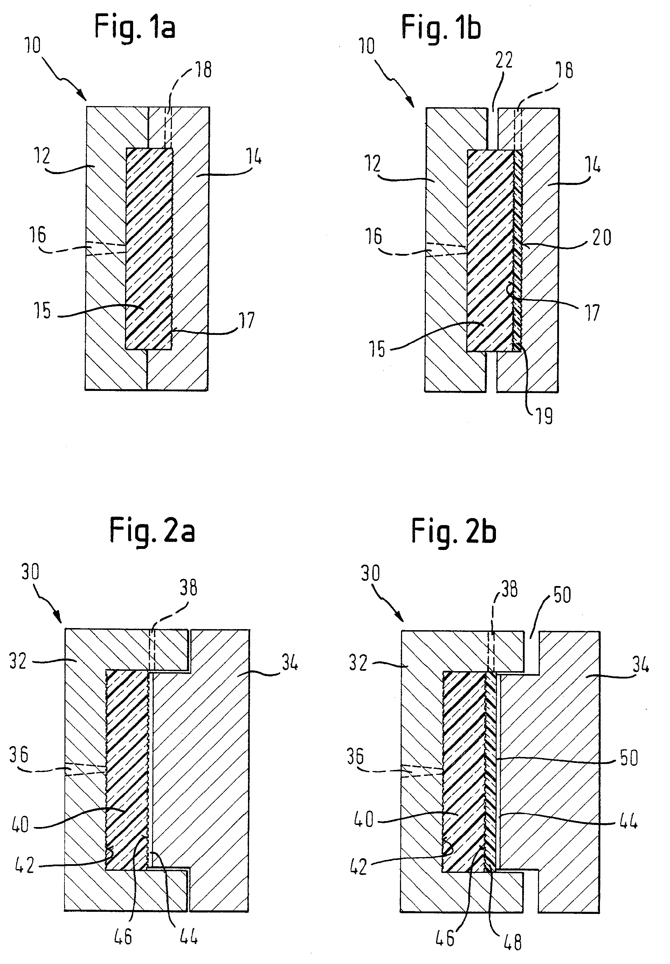

Die vorliegende Erfindung wird nachfolgend anhand zweier Ausführungsbeispiele näher erläutert. Die Zeichnungen zeigen in
Fig. 1 a: in schematischer Schnittdarstellung ein geschlossenes Werkzeug mit eingefülltem Substratmaterial,
Fig. 1 b: das geringfügig geöffnete Werkzeug aus Fig. 1 mit überflutetem Substrat,
Fig. 2a: eine weitere Ausführungsform eines Werkzeugs in schematischer Darstellung mit eingefülltem Substratmaterial und
Fig. 2b: das in Fig. 2a dargestellte Werkzeug in geringfügig aufgezogener Form.

In den Figuren 1a bis 2b ist lediglich ein möglicher Verfahrensablauf mit zwei verschiedenen Formwerkzeugen dargestellt. Die an sich bekannten weiteren Vorrichtungseinheiten, wie Schließeinheit, Einspritzeinheit, PUR-Einheit, etc. werden der Einfachheit halber nicht dargestellt. Anhand der nachfolgenden Ausführungen ist jedoch allgemein klar, wie diese Vorrichtungseinheiten gewählt bzw. ausgestaltet werden müssten.

Die in den Fig. dargestellten Formwerkzeuge sind in an sich bekannter Weise in einer Schließeinheit einer Kunststoffmaschine aufgenommen, wobei diese Maschine ebenfalls eine Plastifiziereinheit für ein thermoplastisches Material sowie eine PUR-/RIM-Einheit für die Überflutung eines Substrats aufweist.

In Fig. 1a ist ein Formwerkzeug 10 mit zwei Formwerkzeughälften 12 und 14 gezeigt, wobei die Formwerkzeughälften 12 und 14 in geschlossenem Zustand dargestellt sind. Die Formwerkzeughälfte 12 weist einen Einspritzkanal 16 auf, durch den ein thermoplastisches Schmelzematerial aus einer (nicht dargestellten) Plastifiziervorrichtung in den Kavitätsraum zwischen den beiden Formwerkzeughälften eingebracht werden kann. Die Formwerkzeughälfte 14 weist einen weiteren Einfüllkanal 18 auf, durch den ein Polyurethanmaterial, wie später noch erläutert wird, zum Überfluten einer zuvor gebildeten Substratschicht eingebracht werden kann.

Dieser Einfüllkanal 18 ist mit einem nicht dargestellten Mischkopf verbunden, aus dem das Polyurethanmaterial zur Verfügung gestellt wird.

Zu erwähnen ist noch, dass die Kavitätsoberfläche der Formwerkzeughälfte 14 mit einer Mikrostruktur 17 versehen ist.

Beim ersten Schritt wird, wie in Fig. 1a dargestellt ist, ein Substratmaterial 15 in die Kavität eingebracht. Das Substratmaterial füllt die Kavität aus und die Mikrostruktur 17 prägt sich auf der Oberfläche des herzustellenden Substrats ab.

Nach dem Aushärten des Substrats wird, wie in Fig. 1 b dargestellt ist, die rechte Formwerkzeughälfte 14 etwas aufgezogen, wodurch es auf der Oberfläche des Substrats zu einer Teilentformung kommt. Durch das Aufziehen bildet sich ein dünner Kavitätsspalt - in Fig. 1 b rechts des Substrats 15 - aus. In diesem Kavitätsspalt wird über den Einfüllkanal 18 das Polyurethanmaterial in niedrig viskoser Form eingefüllt bzw. eingegossen. Das Polyurethanmaterial verteilt sich aufgrund der niedrigen Viskosität problemlos im ganzen Kavitätsspalt. Da die Oberfläche der Formwerkzeughälfte 14 weiterhin mit der Mikrostruktur versehen ist, bildet sich auch auf der Deckfläche diese Mikrostruktur ab, so dass der zu erzielende Effekt einer Entspiegelung bei einem fertigen Produkt erreicht werden kann. Natürlich muss dazu sowohl das Substrat wie auch das eingefüllte Polyurethanmaterial in einer optisch transparenten Form vorliegen. Dass die abgebildete Mikrostruktur zwischen dem Substrat und der Deckschicht wirksam ist, sollten die beiden Materialien einen unterschiedlichen Brechungsindex aufweisen.

Eine alternative Ausgestaltung eines Werkzeugs wird mit Bezug auf die Figuren 2a und 2b beschrieben. In diesen Figuren ist ein Werkzeug 30 mit zwei Formwerkzeughälften 32 und 34 nach Art eines Tauchkantenwerkzeugs ausgebildet, wobei bei vollständig geschlossenem Werkzeug (Fig. 2a) ein Kavitätsraum entsteht, in dem über den Anguss 36 ein Thermoplastmaterial eingebracht werden kann. Beide Kavitätsoberflächen 42 und 46 sind nun mit einer Mikrostruktur ausgebildet, so dass sich auf dem eingebrachten Substrat 40 auf beiden Seiten eine Oberfläche die Mikrostruktur abbildet.

Bei der Ausführungsform in Fig. 2a ist die Kavitätsoberfläche der Formwerkzeughälfte 34 mit einer Heizung 44 ausgebildet, die dicht unterhalb der Oberfläche vorliegt. Diese Heizung kann beispielsweise mittels einer elektrisch leitfähige Keramik oder aber über eine unter Oberflächenschicht liegenden Heizspirale realisiert werden. Natürlich kann auch in der anderen Formwerkzeughälfte 32 (vorliegend nicht dargestellt) eine entsprechende Heizung angeordnet sein. Darüber hinaus - und auch dies ist nicht dargestellt - können auch Kühlkanäle in den Formwerkzeughälften 32 und 34 unter der Kavitätsoberfläche vorhanden sein.

In Fig. 2a ist das eingebrachte Substratmaterial 40 zu erkennen, wobei hier zum Ausbilden dieser Substratschicht 40 ein Prägeschritt angewandt wurde. D. h. es wurde in ein etwas vergrößertes Kavitätsvolumen eingespritzt und dann ein Prägeschritt durchgeführt, bei dem das Formwerkzeug auf die endgültige Kavitätsgröße zusammengefahren wird. Die Heizung der Kavitätsoberfläche unterstützt dabei die Abbildung der Mikro- oder Nanostrukturen auf der Oberfläche des Substrats.

Vorteilhaft bei der Ausführungsform in Fig. 2a ist, dass der Kanal 38, über den nachfolgend noch die Überflutung durchgeführt werden soll, durch die Formwerkzeughälfte 34 zunächst verdeckt und somit verschlossen ist, so dass kein Thermoplastmaterial in diesen Kanal eindringen kann.

Nach dem Aushärten des Substratmaterials 40 wird dann die Werkzeugformhälfte 34 etwas geöffnet, so dass wiederum ein Kavitätsspalt entsteht, in den nunmehr über den geöffneten Kanal 38 das bei der Aushärtung zu vernetzende und insbesonders optisch hochtransparente Deckmaterial in den Kavitätsspalt eingebracht wird. Auch hierbei bildet sich wiederum die Mikrostruktur auch auf der Deckschicht ab. Auch beim Einbringen des für die Deckschicht verwendeten Polyurethanmaterials hilft die Beheizung zur Erhöhung der Abformgenauigkeit, zur Verbesserung der Fließfähigkeit und unterstützt darüber hinaus die Vernetzungsreaktion. Die Deckschicht schützt nach dem Aushärten gegen Verkratzen und ist dementsprechend hart ausgebildet.

Sollten die beiden Seiten des in den Fig. gebildeten Gegenstandes in gebrauchsbeständiger Weise gegen Verkratzen geschützt sein, so können natürlich die beiden Seiten mit dem vernetzenden Polyurethanmaterial überflutet werden. Dazu wären die in den Fig. gezeigten Formen, wie auch die Verfahrensabläufe entsprechend anzupassen.

Insgesamt lässt sich mit der vorliegenden Erfindung auf einfache und kostengünstige Weise ein Verfahren angeben, mit dem Bauteile hergestellt werden können, die gebrauchsbeständige Mikro- oder Nanostrukturen aufweisen.

## Patentansprüche

1. Verfahren zur Herstellung eines Bauteils mit Mikro- oder Nanostruktur mit den Schritten:
- Herstellen eines Substrates durch einen Spritzgieß- oder Spritzprägeprozess, wobei auf einer Oberfläche des Substrates eine Mikro- oder Nanostruktur aufgebracht, insbesondere aufgeprägt, wird, und
- Überfluten des Substrates mit einem vernetzenden, aushärtenden Material.

2. Verfahren nach Anspruch 1,
**dadurch gekennzeichnet,**
**dass** beim Überfluten des Substrates eine Oberfläche der gebildeten Deckschicht ebenfalls mit einer Mikro- oder Nanostruktur ausgebildet wird.

3. Verfahren nach Anspruch 1 oder 2,
**dadurch gekennzeichnet,**
**dass** bei oder nach der Herstellung des Substrates eine andere Oberfläche als die überflutete oder die zu überflutende Substratoberfläche mit einer Mikro- oder Nanostruktur ausgebildet wird.

4. Verfahren zur Herstellung eines Bauteils mit Mikro- oder Nanostruktur mit den Schritten:
- Herstellen eines Substrates durch einen Spritzgieß- oder Spritzprägeprozess und
- Überfluten des Substrates mit einem vernetzenden Material, wobei beim Überfluten des Substrates eine Oberfläche der so gebildeten Schicht mit einer Mikro- oder Nanostruktur ausgebildet wird.

5. Verfahren nach Anspruch 4,
**dadurch gekennzeichnet,**
**dass** das Substrat zum Überfluten in einer Kavität aufgenommen wird.

6. Verfahren nach Anspruch 4 oder 5,
**dadurch gekennzeichnet,**
**dass** bei oder nach der Herstellung des Substrates eine andere Oberfläche als die überflutete oder die zu überflutende Substratoberfläche ebenfalls mit einer Mikro- oder Nanostruktur ausgebildet wird.

7. Verfahren nach einem der vorherigen Ansprüche,
**dadurch gekennzeichnet,**
- **dass** das Substrat in einer ersten Kavität eines ersten Formwerkzeugs angeordnet wird, wobei bei geschlossenem Formwerkzeug auf der zu überflutenden Oberfläche des Substrats ein Kavitätsspalt gebildet ist und
- **dass** in den Kavitätsspalt das vernetzende Material eingefüllt wird.

8. Verfahren nach einem der vorhergehenden Ansprüche,
**dadurch gekennzeichnet,**
**dass** das Substrat in einer zweiten Kavität durch Einspritzen von Kunststoffmaterial ausgebildet wird.

9. Verfahren nach einem der vorhergehenden Ansprüche 7 oder 8,
**dadurch gekennzeichnet,**
**dass** zumindest eine Kavitätsoberfläche mit einer abzuformenden Mikro- oder Nanostruktur ausgebildet ist.

10. Verfahren nach Anspruch 9,
**dadurch gekennzeichnet,**
**dass** zumindest die Kavitätsoberfläche mit der abzuformenden Mikro- oder Nanostruktur beheizt und/oder gekühlt wird.

11. Verfahren nach einem der vorhergehenden Ansprüche,
**dadurch gekennzeichnet,**
**dass** als Material ein Polyurethanmaterial, ein Klarlack, insbesondere ein UV-aushärtbarer Klarlack, ein Acryllack oder ein Epoxydharz verwendet wird.

12. Verfahren nach einem der vorhergehenden Ansprüche,
**dadurch gekennzeichnet,**
**dass** bei der Herstellung des Substrates oder der Überflutungs-Schicht ein Prägeschritt verwendet wird.

13. Verfahren nach einem der vorhergehenden Ansprüche,
**dadurch gekennzeichnet,**
**dass** die Materialien so gewählt sind, dass sie nach dem Aushärten oder Vernetzen optisch transparent, insbesondere hochtransparent, vorliegen.

14. Verfahren nach einem der vorhergehenden Ansprüche,
**dadurch gekennzeichnet,**
**dass** das Substrat und das Überflutungsmaterial nach dem Aushärten eine unterschiedlichen Brechungsindex aufweisen.

15. Verfahren nach einem der vorhergehenden Ansprüche,
**dadurch gekennzeichnet,**
**dass** mehrere Oberflächen des Substrats mit einem vernetzenden, aushärtenden Material überflutet werden.

16. Verfahren nach einem der vorhergehenden Ansprüche,
**dadurch gekennzeichnet,**
**dass** die Herstellung des Substrats sowie das Überfluten eines bereits hergestellten Substrates zyklusgleich vorgenommen wird.

17. Verfahren nach einem der vorhergehenden Ansprüche,
**dadurch gekennzeichnet,**
**dass** ein Funktionselement, insbesondere eine Funktionsschicht, zwischen dem Substrat und der durch Überflutung gebildeten Schicht ein angeordnet wird.

18. Verfahren nach Anspruch 17,
**dadurch gekennzeichnet,**
**dass** als Funktionselement eine Leuchtfolie dient.

19. Verfahren nach Anspruch 17 oder 18,
**dadurch gekennzeichnet,**
**dass** das Funktionselement mit einer lichtbeugenden Eigenschaft ausgebildet wird.

20. Vorrichtung zur Durchführung eines der in den Ansprüchen 1 bis 19 angegebenen Verfahren, umfassend
- ein erstes Formwerkzeug, in dem ein Substrat positionierbar ist, wobei nach der Positionierung des Substrates zumindest an einer Seite ein Kavitätsspalt ausbildbar ist, und wobei eine Kavitätsoberfläche eine Mikro- oder Nanostruktur aufweist, und
- eine Einbringvorrichtung mit der ein vernetzendes Material mit vor der Aushärtung niedriger Viskosität in den Kavitätsspalt unter Ausbildung einer Mikro- oder Nanostruktur einbringbar ist.

21. Vorrichtung nach Anspruch 20,
**dadurch gekennzeichnet,**
- **dass** ein zweites Formwerkzeug vorgesehen ist, in dem das Substrat durch Einspritzen eines Kunststoffmaterials ausbildbar ist, und
- **dass** eine Einspritzvorrichtung zum Einbringen des Substratmaterial in eine Kavität des zweiten Formwerkzeugs vorgesehen ist.

22. Vorrichtung nach Anspruch 21,
**dadurch gekennzeichnet,**
**dass** das erste Formwerkzeug, das zweite Formwerkzeug, die Einbringvorrichtung zum Einbringen des vernetzenden Materials und die Einspritzvorrichtung zum Einbringen des Substratmaterial derart ausgebildet und angeordnet sind, dass sowohl das Einbringen des vernetzenden Materials wie auch das Einbringen des Substratmaterial zuklusgleich durchführbar ist.

23. Vorrichtung nach Anspruch 22,
**dadurch gekennzeichnet,**
**dass** die Formwerkzeug in einer Wendeplatten-, Schiebetisch- oder Drehtisch-Schließeinheit angeordnet sind.

24. Vorrichtung nach Anspruch 23,
**dadurch gekennzeichnet,**
**dass** das erste und das zweite Formwerkzeug identisch sind und eine Schließeinrichtung zur Aufnahme des Formwerkzeugs derart ausgebildet ist, dass durch Aufziehen des Formwerkzeugs nach dem Bilden des Substrates der Kavitätsspalt zum Überfluten des Substrates bildbar ist.

25. Vorrichtung nach einem der Ansprüche 20 bis 24,
**dadurch gekennzeichnet,**
**dass** eine Heizeinrichtung vorgesehen ist, mit der zumindest die mit der Mikro- oder Nanostruktur versehenen Kavitätsoberfläche beheizbar ist.

26. Vorrichtung nach einem der Ansprüche 20 bis 25,
**dadurch gekennzeichnet,**
**dass** das Formwerkzeug in einer Schließeinheit aufgenommen ist und die Schließeinheit zur Durchführung eines Prägeschrittes ausgebildet ist.
